# FASCICULE DE BREVET EUROPEEN

(11) **EP 3 351 009 B1**
(45) Date de publication et mention de la délivrance du brevet: **05.06.2019**
(21) Numéro de dépôt: 16806238.8
(22) Date de dépôt: 28.10.2016
(51) Int. Cl.: H04Q 1/02

(54) **PANNEAU DE BRASSAGE COMPRENANT UN DISPOSITIF D'ACCROCHAGE DE TIROIR**
SCHALTTAFEL MIT EINER VORRICHTUNG ZUR BEFESTIGUNG EINES STECKMODULS
PATCH PANEL COMPRISING A DEVICE FOR ATTACHING A PLUG-IN MODULE

(30) Priorité: 17.11.2015 FR 1561032
(43) Date de publication de la demande: 25.07.2018
(73) Titulaire: Legrand France, 87000 Limoges (FR); Legrand SNC, 87000 Limoges (FR)
(72) Inventeur: PALUMBO, Alain, 26300 Chatuzange Le Goubet (FR)
(74) Mandataire: Novagraaf Technologies
(86) Numéro de dépôt international: PCT/FR2016/052811
(87) Numéro de publication internationale: WO 2017/085371

(56) Documents cités:
- US-A1- 2002 117 942
- US-A1- 2006 018 622
- US-A1- 2010 310 225

## Description

### 1. Domaine de l'invention

L'invention concerne le domaine des installations de réseaux informatiques et de télécommunications. Elle concerne plus particulièrement un panneau de brassage et son dispositif d'accrochage de tiroir.

### 2. Art antérieur

Un panneau de brassage permet de réaliser des liens entre plusieurs câbles connectés aux différents ports du panneau en reliant les ports concernés au moyen de cordons de brassage. En particulier, les panneaux de brassage de connecteurs RJ45 permettent de réaliser un câblage entre des câbles à paires torsadées et des cordons RJ45 afin d'établir des liens entre différents périphériques.

Certains panneaux comportent des tiroirs placés dans un châssis dans des logements dédiés permettant de faire coulisser une rangée de connecteurs supportés par le tiroir pour accéder plus facilement aux câbles reliés aux connecteurs. De tels panneaux sont par exemple décrits par le document US 2006/018622 A1.

Les panneaux actuels ne sont pas conçus de sorte à ce que le tiroir support de connecteurs soit totalement extrait hors du châssis du panneau de brassage en phase de montage des câbles. L'ouverture dans la face avant du panneau n'est alors pas suffisamment dégagée pour permettre un montage ergonomique des câbles et des connecteurs à l'intérieur du panneau.

Par ailleurs, au cours du chantier d'installation du panneau, les tiroirs sont classiquement posés à l'écart de la zone d'intervention, voire posés au sol, avant d'être montés, ce qui peut engendrer des dégradations accidentelles des tiroirs.

### 3. Objectifs de l'invention

La présente invention propose une solution visant à pallier les inconvénients précités. Un objectif de l'invention est de maintenir un tiroir accroché au châssis alors qu'il est totalement extrait de son logement.

### 4. Résumé de l'invention

L'invention concerne un panneau de brassage comportant un châssis, au moins un tiroir comportant des connecteurs, agencé de manière à coulisser entre une position enfoncée dans laquelle le tiroir est placé dans un logement du châssis et une position extraite dans laquelle le tiroir est en dehors du logement, c'est-à-dire complètement dissocié du châssis, le panneau comportant en outre un dispositif d'accrochage du tiroir au châssis, le dispositif d'accrochage comportant au moins un corps allongé flexible agencé de manière à coulisser par rapport au châssis et/ou au tiroir ; une première extrémité agencée de manière à accrocher le tiroir au dispositif d'accrochage en position extraite du tiroir ; et une deuxième extrémité agencée de manière à accrocher le dispositif d'accrochage au châssis en position extraite du tiroir.

On entend par panneau de brassage un dispositif comportant une pluralité de connecteurs, utilisé dans des installations de réseaux informatiques et de télécommunications pour relier différents périphériques entre eux au travers de liens établis entre des connecteurs du panneau.

Selon un mode de réalisation particulier, le tiroir et/ou le châssis comporte un passage agencé de manière à permettre à l'au moins un corps allongé d'y coulisser.

Selon un mode de réalisation particulier, la première extrémité comporte une butée agencée de manière à entrer en butée avec le passage lorsque le tiroir est en position extraite ; et/ou la deuxième extrémité comporte une butée agencée de manière à entrer en butée avec le passage lorsque le tiroir est en position extraite.

Selon un mode de réalisation particulier, le passage comporte une portion agencée de manière à permettre l'insertion de la butée dans le passage par l'intermédiaire de la portion en phase d'assemblage.

Selon un mode de réalisation particulier, la butée comporte une forme évasée et évidée en son centre, apte à se déformer de sorte à permettre une entrée en force dans le passage.

Selon un mode de réalisation particulier, le tiroir et/ou le châssis comporte une glissière agencée de manière à permettre à l'au moins un corps allongé d'y coulisser. Avantageusement, la portion du passage permettant l'insertion de la butée se situe dans la glissière.

Selon un mode de réalisation particulier, la première extrémité est en liaison fixe avec le tiroir.

Selon un mode de réalisation particulier, la première extrémité est agencée de manière à coulisser par rapport à un premier passage et la deuxième extrémité est agencée de manière à coulisser par rapport à un deuxième passage.

Selon un mode de réalisation particulier, la deuxième extrémité est en liaison fixe avec le châssis.

Selon un mode de réalisation particulier, le châssis comportant un plan de coulissement sur lequel coulisse le tiroir, l'au moins un corps allongé comporte une surface plane apte à coulisser sur ledit plan de coulissement.

Selon un mode de réalisation particulier, l'au moins un corps allongé est en matière thermoplastique telle que le polypropylène.

### 5. Liste des figures

D'autres caractéristiques et avantages innovants ressortiront de la description ci-après, fournie à titre indicatif et nullement limitatif, en référence aux dessins annexés, dans lesquels :
- La figure 1 représente une vue schématique d'un premier mode de réalisation de l'invention ;
- La figure 2 représente une vue schématique d'un deuxième mode de réalisation de l'invention ; et
- La figure 3 représente une vue schématique du dispositif d'ancrage d'un troisième mode de réalisation de l'invention.

### 6. Description détaillée

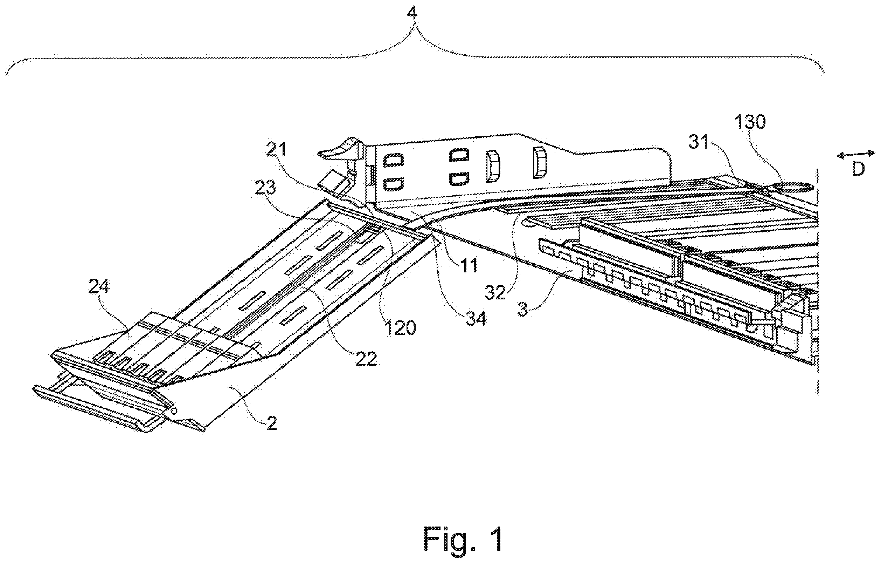

En référence aux figures 1 à 3 est représenté un panneau 4 de brassage. Selon un premier mode de réalisation représenté à la figure 1, le panneau 4 est un panneau de connecteurs RJ45.

Le panneau 4 comporte un châssis 3, un tiroir 2 support de connecteurs et un dispositif 1 d'accrochage du tiroir 2 au châssis 3.

Le tiroir 2 est agencé de manière à coulisser dans un logement du châssis 3 selon une direction D de coulissement et sur un plan P de coulissement. Le tiroir 2 présente une position enfoncée dans laquelle le tiroir 2 est placé dans le logement et une position extraite dans laquelle le tiroir 2 est en dehors du logement. Le tiroir est extrait du châssis par une ouverture 34 du châssis.

Le tiroir 2 comporte des connecteurs 24 fixés sur la face avant du tiroir 2 et formant au moins une rangée de connecteurs. La face avant du tiroir 2 est la face qui occulte au moins partiellement l'ouverture 34 lorsque le tiroir 2 est en position enfoncée.

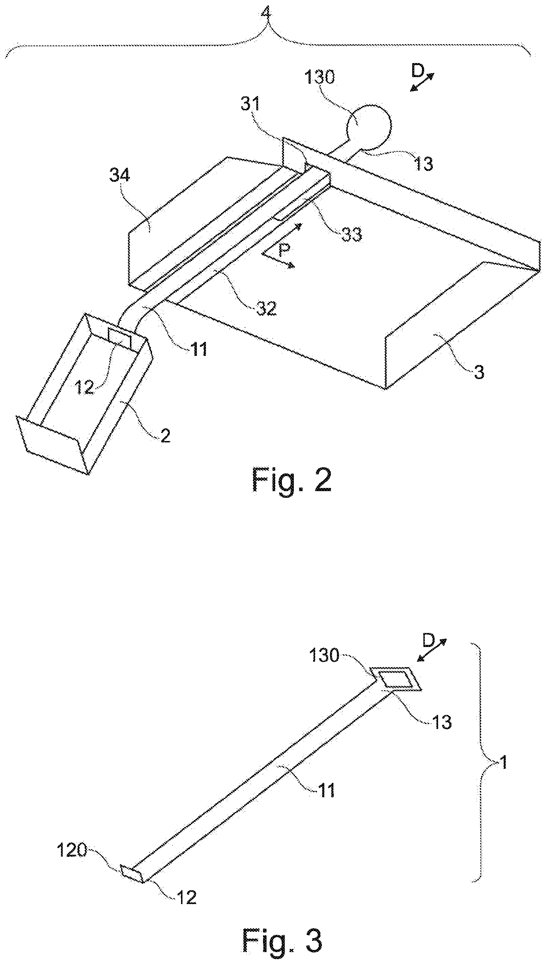

En référence plus particulièrement à la figure 3, le dispositif 1 d'accrochage comporte un corps allongé 11 selon la direction D de coulissement, une première extrémité 12 agencée de manière à accrocher le tiroir 2 au dispositif 1 en position extraite du tiroir 2 et une deuxième extrémité 13 agencée de manière à accrocher le dispositif 1 au châssis 3 en position extraite du tiroir 2.

En référence à la figure 1, le châssis 3 comporte un passage 31 agencé dans une bague de manière à permettre au corps allongé 11 d'y coulisser. La figure 2 représente un mode de réalisation différent dans lequel le passage 31 est un orifice traversant dans la face arrière du châssis, la face arrière étant opposée à l'ouverture 34. En variante, le passage est agencé dans une excroissance de la face horizontale du châssis 3 sur laquelle coulisse le tiroir 2 parallèlement au plan P de coulissement.

En référence aux figures 1 et 3, l'extrémité 13 du dispositif 1 comporte une forme évasée et évidée en son centre, apte à se déformer, permettant une entrée en force dans le passage 31. La forme évasée est agencée de manière à entrer en butée avec le passage 31 lorsque le tiroir 2 est en position extraite. La butée ainsi obtenue permet de bloquer le coulissement du corps allongé 11 dans le passage et ainsi de maintenir le dispositif 1 accroché au châssis 3. Avantageusement, la forme évasée est parallélépipédique, cylindrique ou prismatique. La figure 2 représente un mode de réalisation différent dans lequel l'extrémité 13 comporte une forme évasée pleine et sphérique. En variante, la forme évasée a une autre forme permettant une butée avec le passage. Selon un mode de réalisation préféré, le passage 31 comporte une première portion d'insertion 33 agencée de manière à permettre l'insertion de l'extrémité 13 dans le passage 31 par l'intermédiaire de la première portion d'insertion 33 en phase d'assemblage. La première portion d'insertion 33 est agencée de sorte à bloquer la sortie de l'extrémité 13 par le passage 31 lorsque le tiroir 2 coulisse sur le plan P de coulissement.

Le châssis 3 comporte une glissière 32 agencée de manière à guider le coulissement du dispositif 1 dans le châssis 3. Selon un mode de réalisation préféré, la première portion d'insertion 33 se situe dans la glissière 32.

En référence à la figure 1, le tiroir 2 comporte un passage 21, sous forme d'un trou traversant dans la face arrière du tiroir 2 opposée à la face comportant les connecteurs, agencé de manière à permettre au corps allongé 11 d'y coulisser. Selon différents modes de réalisation, le passage 21 est un orifice dans une bague solidaire du tiroir 2 ou un orifice dans une excroissance d'une face du tiroir telle que la face inférieure du tiroir 2 destinée à reposer sur le plan P de coulissement.

Selon un mode de réalisation particulier non représenté, le passage 21 comporte une deuxième portion d'insertion 23 agencée de manière à permettre l'insertion de l'extrémité 12 dans le passage 21 par l'intermédiaire de la deuxième portion d'insertion en phase d'assemblage, de manière analogue à ce qui est décrit pour la première portion d'insertion 33.

Le tiroir 2 comporte une glissière 22 agencée de manière à guider le coulissement du dispositif 1 dans le tiroir 2. Selon le mode de réalisation de la figure 1, la deuxième portion d'insertion 23 se situe dans la glissière 22.

Dans le mode de réalisation de la figure 1, le dispositif 1 coulisse par rapport au châssis 3 et par rapport au tiroir 2.

En référence à la figure 2 est représenté un panneau 4 de brassage selon un deuxième mode de réalisation de l'invention. Dans ce deuxième mode de réalisation, l'extrémité 12 est fixée au tiroir 2. Les modes de fixation suivants permettent de fixer l'extrémité 12 au tiroir 2 : thermo-soudage, vissage, clipsage. Dans ce mode de réalisation, le dispositif 1 coulisse par rapport au châssis 3 mais est fixe par rapport au tiroir 2.

Selon un mode de réalisation non représenté, l'extrémité 13 est fixée au châssis 3. Les modes de fixation cités dans le paragraphe précédent permettent de fixer l'extrémité 13 au châssis 3. Dans ce mode de réalisation, le dispositif 1 coulisse par rapport au tiroir 2 mais est fixe par rapport au châssis 3.

L'invention est décrite dans ce qui précède à titre d'exemple. Il est entendu que la personne de l'art est à même de réaliser différentes variantes de réalisation de l'invention, en associant par exemple les différentes caractéristiques ci-dessus prises seules ou en combinaison, sans pour autant sortir du cadre de l'invention.

## Revendications

1. Panneau (4) de brassage comportant un châssis (3), au moins un tiroir (2) comportant des connecteurs, agencé de manière à coulisser entre une position enfoncée dans laquelle le tiroir (2) est placé dans un logement du châssis (3) et une position extraite dans laquelle le tiroir (2) est en dehors du logement, le panneau (4) étant **caractérisé en ce qu'**il comporte en outre un dispositif (1) d'accrochage du tiroir (2) au châssis (3), le dispositif (1) d'accrochage comportant :
- au moins un corps allongé (11) flexible agencé de manière à coulisser par rapport au châssis (3) et/ou au tiroir (2) ;
- une première extrémité (12) agencée de manière à accrocher le tiroir (2) au dispositif (1) d'accrochage en position extraite du tiroir (2) ; et
- une deuxième extrémité (13) agencée de manière à accrocher le dispositif (1) d'accrochage au châssis (3) en position extraite du tiroir (2).

2. Panneau (4) selon la revendication précédente **caractérisé en ce que** le tiroir (2) et/ou le châssis (3) comporte un passage (21 ou 31) agencé de manière à permettre à l'au moins un corps allongé (11) d'y coulisser.

3. Panneau (4) selon la revendication précédente **caractérisé en ce que** :
- la première extrémité (12) comporte une butée (120) agencée de manière à entrer en butée avec le passage (21) lorsque le tiroir (2) est en position extraite ; et/ou
- la deuxième extrémité (13) comporte une butée (130) agencée de manière à entrer en butée avec le passage (31) lorsque le tiroir (2) est en position extraite.

4. Panneau (4) selon la revendication précédente **caractérisé en ce que** le passage (21 ou 31) comporte une portion (23, 33) agencée de manière à permettre l'insertion de la butée (120, 130) dans le passage (21 ou 31) par l'intermédiaire de la portion (23, 33).

5. Panneau (4) selon les revendications 3 ou 4 **caractérisé en ce que** la butée (120, 130) comporte une forme évasée et évidée en son centre, apte à se déformer de sorte à permettre une entrée en force dans le passage (21 ou 31).

6. Panneau (4) selon l'une quelconque des revendications précédentes **caractérisé en ce que** le tiroir (2) et/ou le châssis (3) comporte une glissière (22 ou 32) agencée de manière à permettre à l'au moins un corps allongé (11) d'y coulisser.

7. Panneau (4) selon l'une quelconque des revendications précédentes **caractérisé en ce que** la première extrémité (12) est en liaison fixe avec le tiroir (2).

8. Panneau (4) selon l'une quelconque des revendications 2 à 6 **caractérisé en ce que** la première extrémité (12) est agencée de manière à coulisser par rapport à un premier passage (21) et la deuxième extrémité (13) est agencée de manière à coulisser par rapport à un deuxième passage (31).

9. Panneau (4) selon l'une quelconque des revendications précédentes **caractérisé en ce que**, le châssis comportant un plan (P) de coulissement sur lequel coulisse le tiroir (2), l'au moins un corps allongé (11) comporte une surface plane apte à coulisser sur ledit plan (P) de coulissement.

10. Panneau (4) selon l'une quelconque des revendications précédentes **caractérisé en ce que** l'au moins un corps allongé (11) est en matière thermoplastique telle que le polypropylène.

## Patentansprüche

1. Schalttafel (4), beinhaltend ein Gestell (3), mindestens ein Steckmodul (2), das Stecker beinhaltet, derart angeordnet, um zwischen einer eingedrückten Position, in der das Steckmodul (2) in einer Aufnahme des Gestells (3) platziert ist, und einer herausgezogenen Position zu gleiten, in der das Steckmodul (2) außerhalb der Aufnahme ist, wobei die Tafel (4) **dadurch gekennzeichnet ist, dass** sie weiter eine Vorrichtung (1) zur Befestigung des Steckmoduls (2) am Gestell (3) beinhaltet, wobei die Vorrichtung (1) zur Befestigung beinhaltet:
- mindestens einen flexiblen länglichen Körper (11), derart angeordnet, um im Verhältnis zu dem Gestell (3) und/ oder dem Steckmodul (2) zu gleiten;
- ein erstes Ende (12), derart angeordnet, um das Steckmodul (2) an der Vorrichtung (1) zur Befestigung in der herausgezogenen Position des Steckmoduls (2) zu befestigen; und
- ein zweites Ende (13), derart angeordnet, um die Vorrichtung (1) zur Befestigung an dem Gestell (3) in der herausgezogenen Position des Steckmoduls (2) zu befestigen.

2. Tafel (4) nach dem vorstehenden Anspruch, **dadurch gekennzeichnet, dass** das Steckmodul (2) und/ oder das Gestell (3) einen Durchgang (21 oder 31) beinhaltet, derart angeordnet, um es dem mindestens einen länglichen Körper (11) zu erlauben, hindurchzugleiten.

3. Tafel (4) nach dem vorstehenden Anspruch, **dadurch gekennzeichnet, dass**:
- das erste Ende (12) einen Anschlag (120) beinhaltet, derart angeordnet, um mit dem Durchgang (21) auf Anschlag zu gehen, wenn das Steckmodul (2) in herausgezogener Position ist; und/ oder
- das zweite Ende (13) einen Anschlag (130) beinhaltet, derart angeordnet, um mit dem Durchgang (31) auf Anschlag zu gehen, wenn das Steckmodul (2) in herausgezogener Position ist.

4. Tafel (4) nach dem vorstehenden Anspruch, **dadurch gekennzeichnet, dass** der Durchgang (21 oder 31) einen Abschnitt (23, 33) beinhaltet, derart angeordnet, um das Einführen des Anschlags (120, 130) in den Durchgang (21 oder 31) über den Abschnitt (23, 33) zu erlauben.

5. Tafel (4) nach den Ansprüchen 3 oder 4, **dadurch gekennzeichnet, dass** der Anschlag (120, 130) eine ausgestellte und in seiner Mitte ausgehöhlte Form beinhaltet, die imstande ist, sich so zu verformen, um einen erzwungenen Eintritt in den Durchgang (21 oder 31) zu erlauben.

6. Tafel (4) nach einem der vorstehenden Ansprüche, **dadurch gekennzeichnet, dass** das Steckmodul (2) und/ oder das Gestell (3) eine Gleitschiene (22 oder 32) beinhaltet, derart angeordnet, um es dem mindestens einen länglichen Körper (11) zu erlauben, hindurchzugleiten.

7. Tafel (4) nach einem der vorstehenden Ansprüche, **dadurch gekennzeichnet, dass** das erste Ende (12) in einer festen Verbindung mit dem Steckmodul (2) ist.

8. Tafel (4) nach einem der Ansprüche 2 bis 6, **dadurch gekennzeichnet, dass** das erste Ende (12) derart angeordnet ist, um im Verhältnis zu einem ersten Durchgang (21) zu gleiten und das zweite Ende (13) derart angeordnet ist, um im Verhältnis zu einem zweiten Durchgang (31) zu gleiten.

9. Tafel (4) nach einem der vorstehenden Ansprüche, **dadurch gekennzeichnet, dass** der mindestens eine längliche Körper (11), da das Gestell eine Gleitebene (P) beinhaltet, auf der das Steckmodul (2) gleitet, eine ebene Oberfläche beinhaltet, die imstande ist, auf der Gleitebene (P) zu gleiten.

10. Tafel (4) nach einem der vorstehenden Ansprüche, **dadurch gekennzeichnet, dass** der mindestens eine längliche Körper (11) aus einem thermoplastischen Material, wie Polypropylen, ist.

## Claims

1. Patch panel (4) comprising a frame (3), at least one drawer (2) comprising connectors, arranged in such a way as to slide between a pushed-in position in which the drawer (2) is placed in a housing in the frame (3) and an extracted position in which the drawer (2) is outside the housing, the panel (4) being **characterised in that** it further comprises a device (1) for attaching the drawer (2) to the frame (3), the attachment device (1) comprising:
- at least one flexible elongate body (11) arranged in such a way as to slide with respect to the frame (3) and/or to the drawer (2);
- a first end (12) designed to attach the drawer (2) to the attachment device (1) in the extracted position of the drawer (2); and
- a second end (13) designed to attach the attachment device (1) to the frame (3) in the extracted position of the drawer (2).

2. Panel (4) as claimed in the preceding claim **characterised in that** the drawer (2) and/or the frame (3) comprises a passage (21 or 31) arranged in such a way as to allow the at least one elongate body (11) to slide therein.

3. Panel (4) as claimed in the preceding claim **characterised in that**:
- the first end (12) comprises an abutment (120) arranged in such a way as to abut against the passage (21) when the drawer (2) is in the extracted position; and/or
- the second end (13) comprises an abutment (130) arranged in such a way as to abut against the passage (31) when the drawer (2) is in the extracted position.

4. Panel (4) as claimed in the preceding claim **characterised in that** the passage (21 or 31) comprises a portion (23, 33) arranged in such a way as to allow for the insertion of the abutment (120, 130) into the passage (21 or 31) via the portion (23, 33).

5. Panel (4) according to claims 3 or 4 **characterised in that** the abutment (120, 130) comprises a flared and recessed shape at its centre, able to be deformed in such a way as to allow for a forced entry into the passage (21 or 31).

6. Panel (4) as claimed in any preceding claim **characterised in that** the drawer (2) and/or the frame (3) comprises a slide (22 or 32) arranged in such a way as to allow the at least one elongate body (11) to slide therein.

7. Panel (4) as claimed in any preceding claim **characterised in that** the first end (12) is fixed to the drawer (2).

8. Panel (4) according to any of claims 2 to 6 **characterised in that** the first end (12) is arranged in such a way as to slide with respect to a first passage (21) and the second end (13) is arranged in such a way as to slide with respect to a second passage (31).

9. Panel (4) as claimed in any preceding claim **characterised in that**, the frame comprising a sliding plane (P) on which the drawer (2) slides, the at least one elongate body (11) comprises a flat surface able to slide on said sliding plane (P).

10. Panel (4) as claimed in any preceding claim **characterised in that** the at least one elongate body (11) is made of a thermoplastic material such as polypropylene.
